# EUROPEAN PATENT APPLICATION

(11) **EP 1 202 144 A1**
(43) Date of publication of application: **02.05.2002**
(21) Application number: 00123166.1
(22) Date of filing: 25.10.2000
(51) Int. Cl.: G05B 19/418

(54) **Method for controlling a process line in semiconductor device manufacturing**

(71) Applicant: Semiconductor300 GmbH & Co KG, 01099 Dresden (DE)
(72) Inventor: Schedel, Thorsten, 01109 Dresden (DE); Seidel, Torsten, 01309 Dresden (DE)
(74) Representative: Fischer, Volker, Dipl.-Ing.

(57) **Abstract**

Using an algorithm for adding additional waiting times (60) to the process times of consecutively arranged processing devices (30) in a control unit (1) of a semiconductor device mass-production process line, the build-up of queues can be avoided resulting in equal time differences between any two manufacturing steps (101-118). The semiconductor devices (10) - the process line being the lithographic step comprising coating 104, exposure 112 and developing 116 - acquire stable process conditions and the yield is significantly increased due to a larger process window.

## Description

Method for controlling a process line in semiconductor device manufacturing

The present invention relates to a method for controlling a process line in semiconductor manufacturing using a control unit, which has an interface to a robot handling semiconductor devices on the process line, the process line having a number of consecutive manufacturing steps, each performed by a different set of processing devices during a process time.

Due to the rapid decrease of minimum structure sizes in semiconductor device manufacturing the requirements for process conditions in order to maintain critical dimension inside given tolerances become increasingly important. One key issue is to use statistical analysis to identify those process parameters, which contribute strongest to critical dimension variations from wafer to wafer. The so-called critical dimension uniformity parameter here represents the range of critical dimension measurements from wafer to wafer and serves as a strength indicator for problems with the process conditions. The kind of statistical distribution can serve as an indicator for the cause of the problem, e.g. a critical dimension drift can point to some continuously changing process parameter.

A prominent example is the timing requirement for the coating, exposing and developing steps in semiconductors mask or wafer fabrication. Once the semiconductor device has been coated with a resist, it becomes important to perform the following manufacturing steps, particularly the exposure, in a time interval, which typically amounts to some hours being dependent on the resist used. Moreover, already within this time interval the resist material continuously changes its physical or chemical constitution. Therefore, one usually tries to process the devices between those time relevant steps as fast as possible.

In mass production, especially in the case of semiconductor wafer fabrication, automatic process lines are often used to coat, expose and develop a device. A process line performing the lithographic step comprises a series of tools each processing tool performing consecutively one of the steps of coating, exposing and developing a semiconductor wafer. The task of handling and forwarding a wafer from one manufacturing step to the next is often performed by a robot, which is controlled by a control unit. This communication is usually done via a standardized SECS/GEM-interface. Thereby, the control unit receives and sends signals for retrieving status information and moving the robot.

In order to reduce costs the process lines are generally operated under full capacity load of, e.g., wafer mass-production. If therefore,a processing tool is busy processing a first wafer, a second wafer that has just finished the manufacturing step leading the current step has to wait until the processing tool releases the first wafer. The control unit and the robot thus have to maintain waiting queues in front of processing tools, which strongly depend on the individual process times of the tools. It is clear that waiting queues increase more and more at locations in front of bottleneck manufacturing steps. Thus, one of the first wafers in a lot will spend less time in the waiting queue as compared with one of the last wafers in a lot, which in general results in a continuous increase of time differences between the actual processing of two manufacturing steps, e.g. coating and exposing.

This introduces a drift in the time interval between the execution of any two manufacturing steps and therefore a drift as well in critical dimension of wafers in a lot with time. This drift leads to an undesired loss of process stability and counteracts any efforts to improve processes in order to accurately reach a given critical dimension. Moreover, the wafer yield is disadvantageously decreased resulting in the necessity for even higher throughput in a process line, which additionally increases queues in front of bottleneck steps.

It is a primary objective of the present invention to increase the yield in semiconductor device manufacturing by providing stable process conditions in a process line.

The objective is solved by a method for controlling a process line in semiconductor device manufacturing using a control unit, which has an interface to a robot handling semiconductor devices on the process line, the process line having a number of consecutive manufacturing steps, each performed by a different set of processing devices during a process time, comprising the steps determination of the maximum number of semiconductor devices, which can be processed in a time interval in each of said manufacturing steps, selection of that manufacturing step, which has the smallest of said numbers of semiconductor devices, setting a clock period of the process line to the process time of said selected manufacturing step divided by the number of processing devices performing said selected manufacturing step, starting the robot in response to a control signal from the control unit for performing the first step of the sequence of manufacturing steps of a first semiconductor device, starting the robot in response to a control signal from the control unit for performing the first step of the sequence of manufacturing steps of a second semiconductor device after a time equal to the clock period.

Using the method according to the present invention a bottleneck manufacturing step, which conventionally leads to a build-up of waiting queues of semiconductor devices, is searched by collecting and determining the semiconductor device throughput data from all processing devices being part of the process line. The throughput data of each processing device, i.e. the maximum number of semiconductor devices, which can be processed in a time interval, are either known to the control unit as default values for the processing machines or have to be introduced to the control unit prior to starting the first wafer, or are just measured by taking the process times of a first pilot wafer or any other semiconductor device.

In some instances one manufacturing step can be performed by a set of processing devices, which results in a multiple throughput as compared to a manufacturing step performed by just one processing device. From the view of line control these manufacturing steps are provided with "effective process times" which are single device processing times reduced by a factor corresponding to the number of processing machines. It is also possible, that two processing devices performing the same manufacturing step comprise different process times and thus different throughputs, in which case the throughput of the least efficient processing device preferably would have to be taken for all processing devices in the corresponding set performing that manufacturing step.

The manufacturing step having the lowest throughput value is then identified as the bottleneck manufacturing step. Since the whole process line cannot have a throughput higher than the throughput of the bottleneck step, the loading step of the process line with semiconductor devices, which is performed by sending a signal from the control unit to the robot, can have the same throughput as the bottleneck manufacturing step without any loss of production efficiency.

Thus, loading the process line with semiconductor devices and using a system clock period for loading time intervals taken as the effective process time of the bottleneck step, instead of loading it with the shorter effective process time of the first handover step of the process line, the same number of semiconductor devices will leave the process line with the same time interval as they are loaded. No waiting queues can build up in front of the bottleneck step, and since there are no waiting times for all semiconductor devices in the process line, they will all experience the same time differences between any two manufacturing steps inside the process line.

Therefore, the semiconductor devices of the same lot gain equal process conditions, and the variations, e.g., in critical dimension are efficiently reduced. The yield of semiconductor devices is advantageously improved, and moreover, devices that still have to be reworked will receive the same process conditions as the first time they moved through the process line and thus will have a higher probability to experience critical dimension measurements inside given tolerances.

The method is preferably implemented as an additional software program module associated with the line control software based in the control unit, but even manual control is possible. The module can be written in Java, C++, Visual Basic, but any other programming language being able to be perform simple mathematical operations are possible as well. The module receives process time information from a database, manual input, or by simply recording the time progress of a pilot semiconductor device. Then, it calculates effective processing times and throughputs for each manufacturing step after which it sorts these manufacturing steps by throughput. Having determined the system clock period from these data the robot is controlled in order to start the processing sequence for each semiconductor device using this clock period as the time interval to perform this task.

A further advantageous aspect considers the adding of additional handling or waiting times to the process times of each of the manufacturing steps after the system clock period has been determined. By setting these waiting times to the difference between the clock period and the individual effective process times of the manufacturing steps the increased effective process times now reveal the same semiconductor device throughput value for all steps. Moreover, this throughput value is the same as the bottleneck step throughput value. Since the throughput of all manufacturing steps are the same, no build-up of waiting queues is possible, and the additional handling times can serve as buffers to readjust a system in case of problems of the processing devices.

In a further aspect the repetition of step (e) of claim 1 is considered, i.e. repeatedly starting the processing of new semiconductor devices with the first manufacturing step with the time difference of the clock period. The method becomes extraordinarily efficient in the case of lots with large numbers of lot elements, for which the process conditions should be exactly the same.

In a further aspect actions are enabled that can be taken, if the configuration of the process line suddenly changes, e.g. when tool problems arise or system maintenance has immediately to be carried out. In this case a new bottleneck location can grow up in the sequence of manufacturing steps or even a barrier step develops, that cannot be surmounted. In order to stay compliant with the aim of establishing equal process conditions the control unit thus advantageously performs a check whether each of the processing devices is still free to process another semiconductor device.

This is considered in the aspect of one processing device out of a set of processing devices is stopped. This event will be signaled to the control unit which then at first carries out a new determination of the bottleneck step and then performing a recalculation of the waiting times for each manufacturing step, thereby repeating steps (a) - (d) of claim 1. Continuing with step (e) the process line is immediately adjusted.

A further aspect considers the case, where all processing devices of a set are not available for further processing a semiconductor device. If this event happens, or if just a significantly smaller bottleneck step develops during processing the control unit is enabled to initiate a complete process line stop. Thereby, the starting of the robot for loading new semiconductor devices to the first manufacturing step is terminated, and for the semiconductor devices which are already in process flow the current manufacturing steps are finished. This provides the advantage, that less semiconductor devices are waiting in the system in a processed status getting unequal process conditions due to larger time differences in their processed times.

Further aspects are evident from the depended claims.

An embodiment of the invention is now described with reference to the drawings. In the drawings:
- Figure 1: displays a lithographic process having a sequence of semiconductor wafer cleantrack and exposure steps.
- Figure 2: shows in a bar chart the flow of twelve semiconductor wafers of a lot through the manufacturing steps vs. time according to prior art.
- Figure 3: gives a demonstration of the communication between a control unit and a robot, which serves a cleantrack and an exposure unit, according to the embodiment of the present invention.
- Figure 4: displays a flow chart of an embodiment according to the method of the present invention.
- Figure 5: shows the configuration of manufacturing steps with processing devices and process times as part of the lithographic process starting from adhesion up to wafer edge exposure.
- Figure 6: displays the flow of a lot of five semiconductor wafers through the manufacturing steps of a first part of the lithographic process (a) according to prior art, (b) according to the method of the present invention using the system clock period as a time delay for wafer starts and (c) according to the method of the present invention using the system clock period and process time added by additional waiting times.

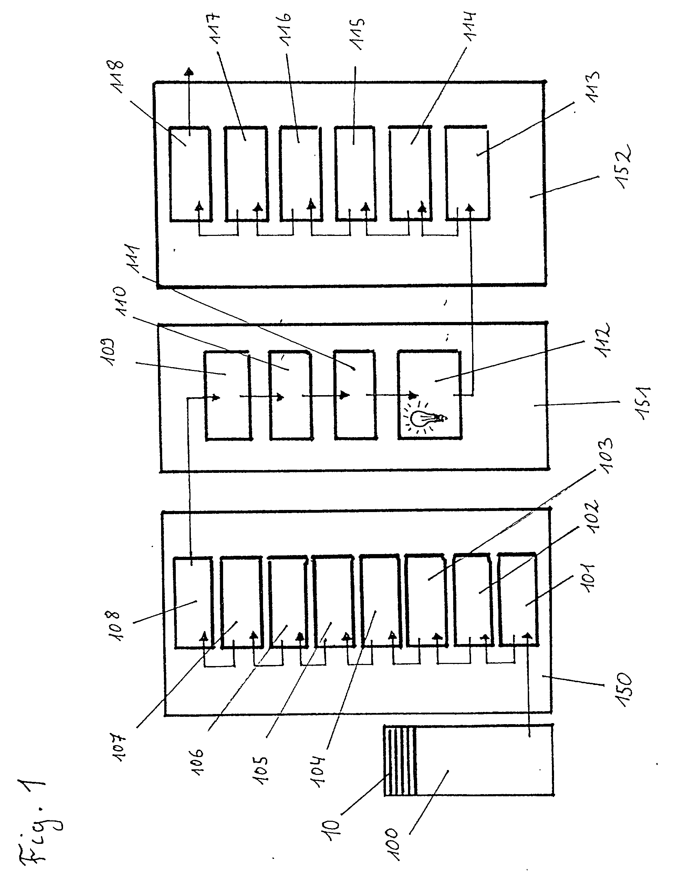

In an embodiment of the method of the present invention the lithographic process in semiconductor wafer manufacturing is considered. Figure 1 gives an impression of 18 subsequent manufacturing steps used in this example in order to project a pattern onto a semiconductor wafer. Having loaded a semiconductor wafer 10 onto a load port 100 these steps comprise: a transition handover 101, adhesion 102, first cooling on a chill-plate 103, coating 104, pre-bake on a hot-plate 105, second cooling on a chill-plate 106, wafer-edge-exposure 107 and a wafer buffer 108 before entering the stepper or scanner 151. These eight manufacturing steps form the first part of a cleantrack 150. The manufacturing steps performed in the stepper or scanner are wait-in-handover 109, pre-alignment 110, wait-in-arm 111 and the central exposure step 112, after which the wafer is turned back to the second part of the clean track 152, to a transition-handover 113. This is followed by post-exposure-bake on a hot-plate 114, a third cooling on a chill-plate 115, developing 116, post-bake on a hot-plate 117 and a handover with cooling on a transition-chill-plate 118, from where the lithographic cluster can be unloaded.

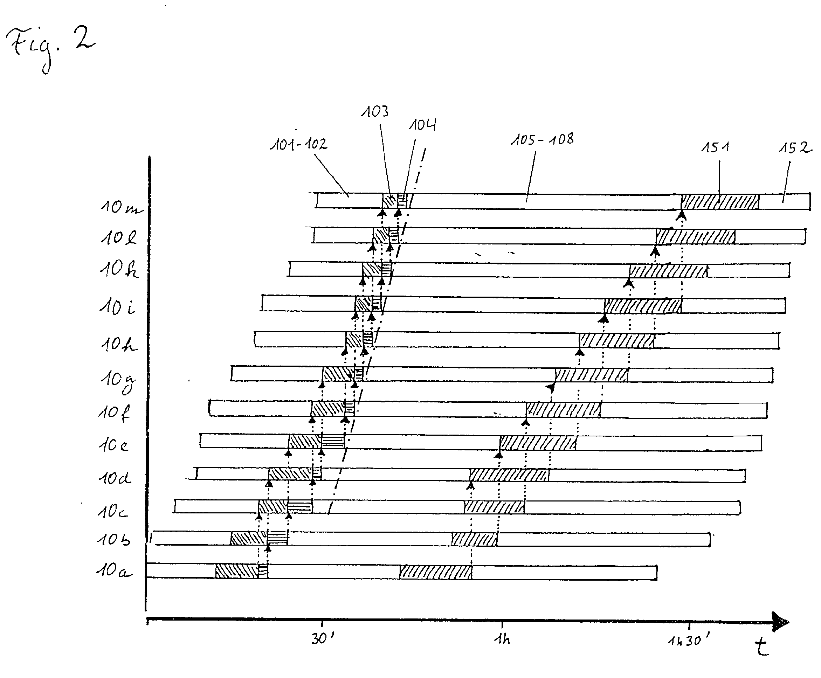

In figure 2 the flow of twelve semiconductor wafers 10a - 10m of a lot through the manufacturing steps 101 - 118 of the clean track 150, 152 and the exposure step 151, which includes the manufacturing steps 109 - 112, is displayed vs. time in a bar chart. In this diagram the length of a bar or a manufacturing step 101 - 118 reflects the time needed to process this manufacturing step, i.e. the process time. The lot displayed in figure 2 is loaded to the process line of the lithographic cluster and controlled in its flow using a conventional, prior art method. This means that the transition handover 101 is reloaded with a semiconductor wafer 10b as soon as a previous semiconductor 10a leaves the transition handover and is moved to the adhesion 102 by a robot 2. For clarity only the manufacturing steps of first cooling on a chill-plate 103 and the coating 104 as well as the exposure steps 151 are marked explicitly in figure 2.

For the first cooling on a chill-plate 103 there are two facilities available, referred to as "processing devices" in this document, which can manufacture semiconductor wafers 10 in parallel. Therefore, after the cooling of a first semiconductor wafer 10a displayed in figure 2 has been started, a second semiconductor wafer 10b has been started to cool with a time delay of roughly process time of the transition handover 101, while the cooling of semiconductor wafer 10a is still being carried out. The transition handover 101 can be performed for just one semiconductor wafer 10 at a time. Once the cooling of semiconductor wafer 10a has finished, a third semiconductor wafer 10c, that is already waiting before the first cooling on a chill-plate 103 can be started on the first cool-plate as indicated by the arrow in figure 2 reaching from the bar of semiconductor wafer 10a to the bar of semiconductor wafer 10c.

For the manufacturing step of coating 104 following the cooling of semiconductor wafers 10 there is only one processing device 30 available, and the varying process times from wafer to wafer indicate, that some waiting time is included here. But from figure 2 a trend is clearly visible, that after the cooling and coating of about five semiconductor wafers 10 the process times of these manufacturing steps 103, 104 significantly shrink leading to a steeper slope in time, i.e. a higher throughput of semiconductor wafers 10 for the first part of the clean track 150 is developing. This may be due to temperature stabilization of the process conditions.

For this process line, i.e. the lithographic cluster, the exposure steps 151, consisting of manufacturing steps 109 - 112, becomes the bottleneck manufacturing steps, as can be seen in figure 2. There are even 3 processing devices 30 performing the exposure step in parallel, but because the process time of the exposure step 151 is about 12 minutes, just 15 semiconductor wafers 10 per hour can be reached as throughput, as compared to 40 - 50 semiconductor wafers 10 per hour in the first cleantrack 150. Therefore, the time interval between coating 104 and the exposure step 151 for the last semiconductor wafer 10m of the test lot already amounts to about one hour, while for the first semiconductor wafers 10a - 10c this time difference has been about 30 minutes. The largest amount of process time within manufacturing steps 105 - 108 can be contributed to the wafer buffer 108, which in principle is a waiting step. For this reason the process conditions, i.e. the time differences between manufacturing steps 101 - 118, changes and critical dimension measurements delivering 200.0 nm for semiconductor wafer 10a drifted to 203.8 nm for semiconductor wafer 10f and 207.2 nm for semiconductor wafer 10m resulting in a wafer-to-wafer uniformity of more than 7 nm.

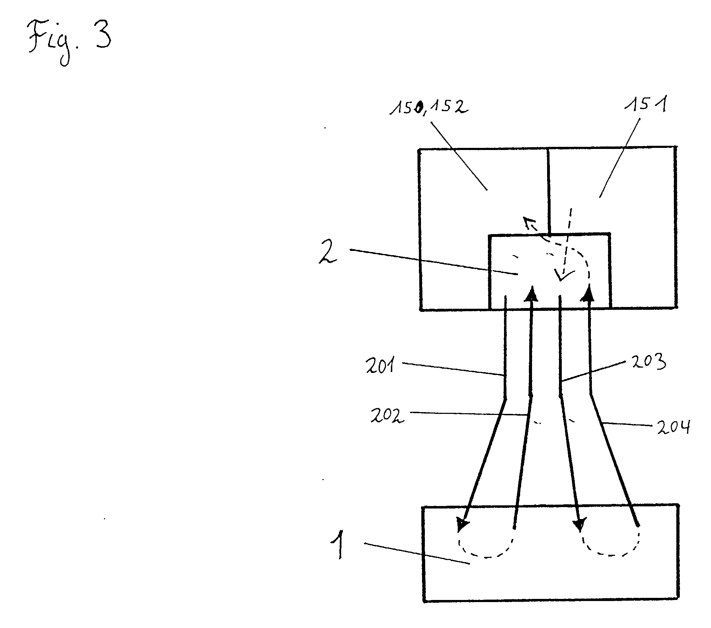

An embodiment of the present invention to be applied to the lithographic cluster process line is displayed in figure 3, where the principle communication between the modules involved is demonstrated. A control unit 1, which can be a line control system comprising a host computer and line control software, receives status information 201 from a robot 2, which serves for forwarding or handling semiconductor devices 10 on cleantracks 150, 152 and exposure units 151. This status information 201 preferentially comprises events like a move-in or move-out of a semiconductor wafer 10 in a processing device 30, or some regularly updated status information. If a move-in is signaled, i.e. a lot is started by e.g. an operator, control unit 1 sends a control signal to robot 2 in order to perform the handling steps necessary for the manufacturing step 101 - 118 under consideration. Using this channel for exchanging information between control unit 1 and robot 2, it becomes possible to perform an advantageous internal synchronization of process and waiting times.

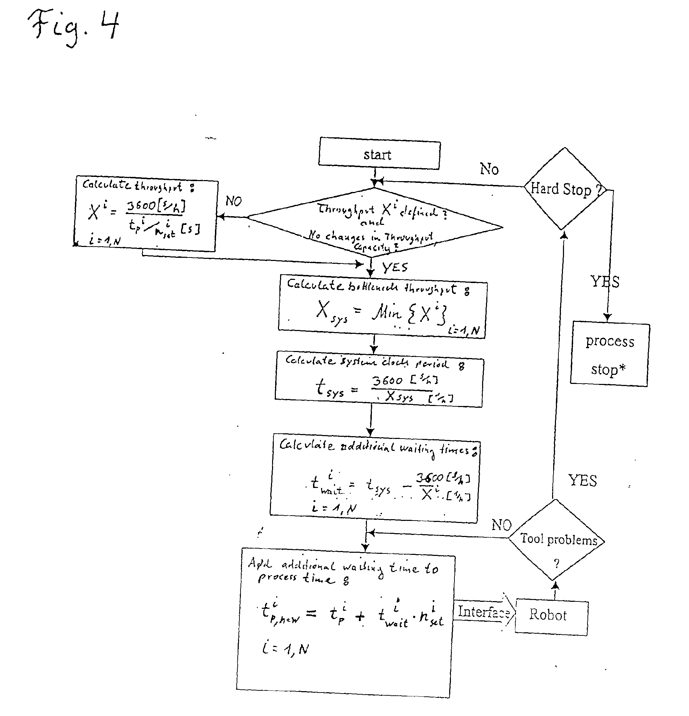

For this purpose the control unit comprises a module, which internally applies an algorithm, which is displayed in figure 4. For all manufacturing step 101 - 118 involved the throughputs of the associated sets of processing devices 20 in units of wafers per hour are once calculated, the system clock period is than derived from the bottleneck throughput, and then additional waiting times are calculated such that when these are added to the process times, the throughput of any manufacturing step 101 - 118 becomes the same value. Having the same throughput values the time differences between manufacturing steps 101 - 118 as they can be seen in figure 2 to increase with time cannot build up. The new process times are signaled to the robot via an SECS/GEM-interface, which is compliant to SEMI standards E4, E5 and E30, in order to hold semiconductor wafers 10 at their current location for the waiting time after finishing the manufacturing step 101 - 118 by, e.g. pin-up-commands in the case of hot-plates or the stand-by-command in the case of coating 104 or any timer control. Having waited for this waiting time the semiconductor wafers 10 are forwarded or handled by the robot 2 as in the conventional case.

A second way of communication between control unit 1 and robot 2 is the external synchronization. An error message 203 can be generated, e.g. on the exposure tool and received by control unit 1 which can be seen in figure 3. Due to the algorithm according to the embodiment of the present invention seen in figure 4 the control unit 1 decides whether a hard stop for the process line is necessary or not. If this is not necessary a recalculation of the throughputs and the system clock periods and therefore of the additional waiting times is nevertheless to be carried out. Once the new waiting times have been calculated they will be reused for the whole lot in any occurrence of a manufacturing step 101 - 118 being finished. A message is then send to the robot so long as no other tool problems occur. If a hard stop is necessary, stop signals for wafer delivery are generated and transferred to the robot and just the steps in progress will be finished, while the loading of new semiconductor wafers 10 to the clean track 150 is terminated. This ensures that just the semiconductor wafers 10 already being in the process line will suffer time interval differences. Thus, the number of critical dimension measurements outside given tolerances are reduced to a minimum and the wafer yield is advantageously increased.

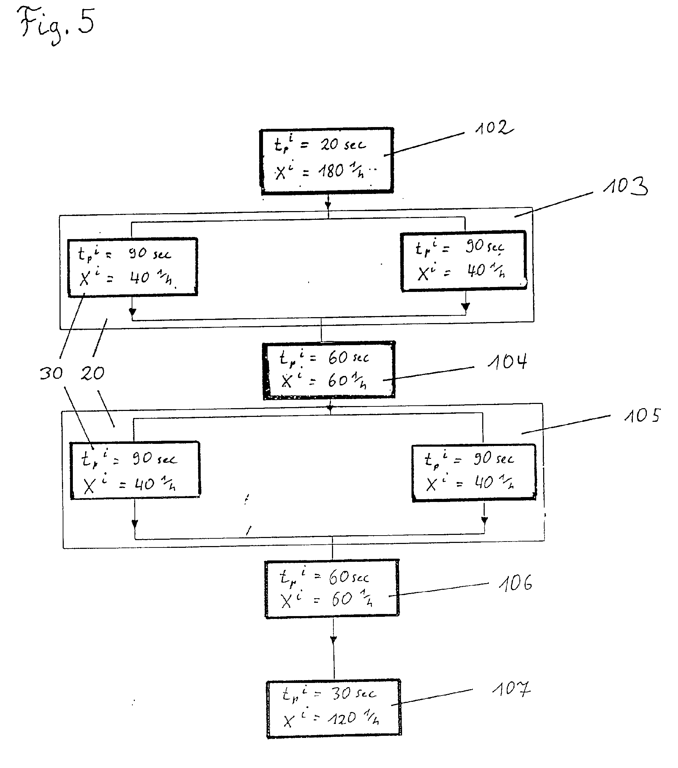

In figure 5 a configuration of manufacturing steps 102 - 107 being a subset of the lithographic cluster is displayed for illustrating the algorithm according to the embodiment of the present invention. Using the process times indicated for each processing device throughput data can be calculated for each manufacturing step 101 - 118, or set of processing devices 20 respectively. Using the formula for throughput given in figure 4 the values displayed in the following table can be derived.

| Manufacturing step | Number of units in set: nₛₑₜ | Throughput: Xᵢ with / without t_{wait} | | Process time tₚ | Waiting Time t_{wait} |
|---|---|---|---|---|---|
| | | [wafers / h] | | [sec] | [sec] |
| 102 | 1 | 180 | 60 | 20 | 40 |
| 103 | 2 | 80 | 60 | 90 | 15 |
| 104 | 1 | 60 | 60 | 60 | 0 |
| 105 | 2 | 80 | 60 | 90 | 15 |
| 106 | 1 | 60 | 60 | 60 | 0 |
| 107 | 1 | 120 | 60 | 30 | 30 |

With 60 wafers per hour the coating 104 has the smallest throughput and can therefore be identified as the bottleneck step, as well as the cooling on a chill-plate 106. Using another formula displayed in figure 4 the system clock period derived is 60 sec. The resulting waiting times as well as the new process times can be found in the table above.

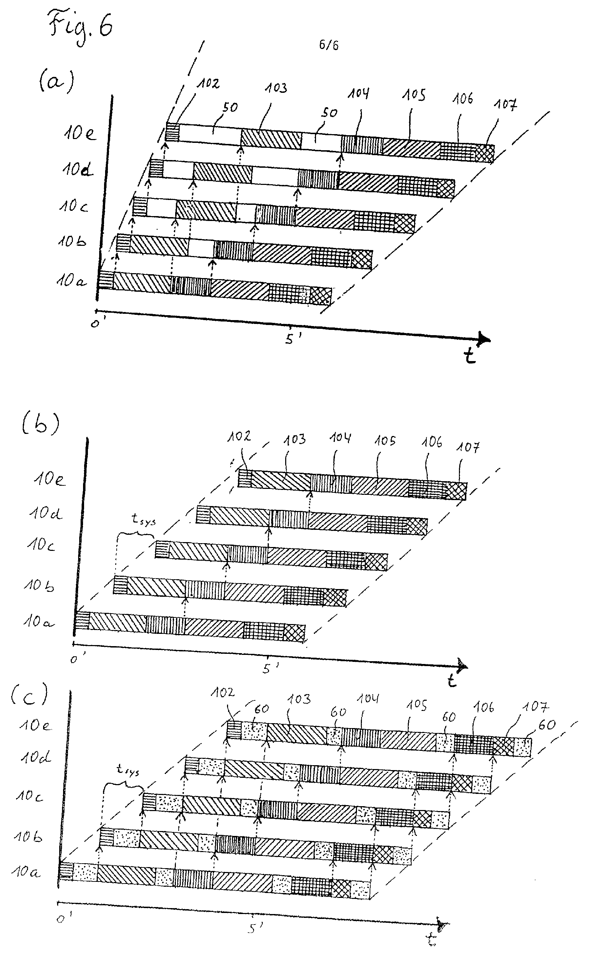

A graphical illustration of these values is shown in figure 6. The prior art case is displayed in figure 6 (a), which is similar to that shown in figure 2. Here, for 5 semiconductor wafers 10a - 10e non-productive queueing times 50 can be noticed prior to the bottleneck step coating 104 as well as before the first cooling on a chill-plate 103 being a bottleneck which is not that narrow. The increase in time intervals between manufacturing steps 102 - 107 is clearly visible. Applying the additional waiting times only to the first manufacturing step, being equal to e.g. starting a semiconductor wafer 10c after a system clock period behind a first semiconductor wafer 10b, no queuing or waiting times are existing at all, which can be seen in figure 6 (b). The time variations in time differences between manufacturing steps 102 - 107 are advantageously removed. Using this algorithm a fast way to process a semiconductor wafer 10 through manufacturing steps 102 - 107 is provided.

In figure 6 (c) the full algorithm applying the additional waiting times 60 is shown to be carried out. The waiting times 60 fill out the process flow for each semiconductor wafer 10a - 10e, such that the throughput of any manufacturing step 102 - 107 is the same. This guarantees that the algorithm according to the embodiment of the present invention can immediately change to new configuration conditions in case of process stops of single processing devices. Moreover, the waiting times 60 provide a smooth transition to new process times. This embodiment advantageously provides a method which significantly reduces the amount of variations in time differences between manufacturing steps 102 - 107 thereby establishing stabile process conditions and proving the wafer-to-wafer critical dimension uniformity.

Considering that the method of the present invention can reduce the wafer-to-wafer uniformity range by 7 nm, when applied to lots suffering variations in times differences between manufacturing steps 101 - 118, the process windows for future node technologies, e.g. DRAM, can be significantly increased. Using current estimations for the critical dimension budget in 2002 a 30 % increase and for 2005 even a 76 % increase in process window is possible.

## Claims

1. Method for controlling a process line in semiconductor device manufacturing using a control unit (1), which has an interface to a robot (2) handling semiconductor devices (10) on the process line, the process line having a number of consecutive manufacturing steps (101-118), each performed by a different set of processing devices (20) during a process time, comprising the steps of
(a) determination of the maximum number of semiconductor devices (10), which can be processed in a time interval in each of said manufacturing steps (101-118),
(b) selection of that manufacturing step, which has the smallest of said numbers of semiconductor devices (10),
(c) setting a clock period of the process line to the process time of said selected manufacturing step divided by the number of processing devices (30) performing said selected manufacturing step,
(d) starting the robot (2) in response to a control signal (202) from the control unit (1) for performing the first step of the sequence of manufacturing steps (101-118) of a first semiconductor device (10a),
(e) starting the robot (2) in response to a control signal (202) from the control unit for performing the first step of the sequence of manufacturing steps (101-118) of a second semiconductor device (10b) after a time equal to the clock period.

2. Method according to claim 1,
**characterised in that**
the control unit (1) adds additional waiting times (60) to said process times of each of said manufacturing steps (101-118) after step (c), which are set to the difference between said clock period and the process times of said manufacturing steps (101-118) divided by the number of processing devices (30) performing said manufacturing steps,
and the robot (2) is started in response to a signal (202) from the control unit (1) for forwarding the semiconductor device after processing through a manufacturing step (101-118) to the next step of it's processing sequence according to the process times added by said waiting times (50).

3. Method according to claim 1 or 2,
**characterised in that**
step (e) is repeated for processing at least another semiconductor device (10).

4. Method according to claim 3,
**characterised in that**
at each time that the robot (2) is started, said control unit (1) checks whether each of the processing devices (30) is free to process another semiconductor device (10).

5. Method according to claim 4,
**characterised in that**
steps (a)-(d) are repeated in the case, that the number of processing devices (30) being free to process a semiconductor device (10) in one of the sets of processing devices (20) has changed in comparison to the previous check by the control unit (1).

6. Method according to one of claims 4 or 5,
**characterised in that**
the repetition of step (e) and the start of any second or further step in the sequence of manufacturing steps (101-118) of a semiconductor device (10) are terminated by the robot (2) in response to a stop signal for device delivery (204) from the control unit (1) in the case, that no processing device (30) in one of the sets of processing devices (20) is free for processing a semiconductor device (10).

7. Method according to one of claims 1 to 6,
**characterised in that**
subsequent manufacturing steps (101-118) comprise the coating (104) of semiconductor devices (10) with a resist, the exposure (112) of semiconductor devices to light, x-rays, ion- or electron beam or the developing (116) of semiconductor masks or wafers.

8. Method according to claim 7,
**characterised in that**
the semiconductor device (10) is a semiconductor wafer, which has a diameter of at least 300 mm.

9. Method according to one of claims 1 to 8,
**characterised in that**
the communication with signals between the control unit (1) and the robot (2) is performed via an interface being compliant to the SEMI-standards E4, E5, E30 and E37.
